Europäisches Patentamt

European Patent Office

Office européen des brevets

(19)

(11) EP 0 602 150 B1

(12) # FASCICULE DE BREVET EUROPEEN

(45) Date de publication et mention
de la délivrance du brevet:
**04.12.1996 Bulletin 1996/49**

(21) Numéro de dépôt: **92919317.5**

(22) Date de dépôt: **01.09.1992**

(51) Int Cl.6: **C23C 14/34**, C23C 14/08

(86) Numéro de dépôt international:
**PCT/FR92/00835**

(87) Numéro de publication internationale:
**WO 93/05195 (18.03.1993 Gazette 1993/08)**

(54) **Elément de cible pour pulvérisation cathodique, procédé de préparation d'un tel élément et cible pour pulvérisation cathodique comportant cet élément**

Target-Element für Kathodenzerstäubung, Verfahren zu dessen Herstellung und Target für Kathodenzerstäubung, welches dieses Element aufweist

Target element for cathode sputtering, manufacturing process thereof, and target for cathode sputtering comprising this element

(84) Etats contractants désignés:
**AT BE CH DE DK ES FR GB GR IE IT LI LU NL SE**

(30) Priorité: **03.09.1991 FR 9110860**

(43) Date de publication de la demande:
**22.06.1994 Bulletin 1994/25**

(73) Titulaire: **ELF AQUITAINE
92400 Courbevoie (FR)**

(72) Inventeurs:
- **CAMPET, Guy
  F-33610 Canejan (FR)**
- **CHABAGNO, Jean-Michel
  F-64000 Pau (FR)**
- **DELMAS, Claude Résidence Bois-d'Arcy
  F-33400 Talence (FR)**
- **PORTIER, Joseph
  F-33170 Gradignan (FR)**
- **SALARDENNE, Jean
  F-33600 Pessac (FR)**

(74) Mandataire: **Boillot, Marc
Elf Aquitaine Production,
Département Propriété Industrielle,
Tour Elf,
Cédex 45
92078 Paris La Défense (FR)**

(56) Documents cités:
**EP-A- 0 342 537**

- **PATENT ABSTRACTS OF JAPAN vol. 10, no. 90 (C-337)(2147) 8 Avril 1986 & JP-A-60 221 569**
- **PATENT ABSTRACTS OF JAPAN vol. 10, no. 287 (C-375)(2343) 30 Septembre 1986 & JP-A-61 104 073**
- **PATENT ABSTRACTS OF JAPAN vol. 9, no. 217 (P-385)(1940) 4 Septembre 1985 & JP-A-60 078 424**
- **PATENT ABSTRACTS OF JAPAN vol. 14, no. 202 (C-713)(4145) 25 Avril 1990 & JP-A-20 43 356**
- **PATENT ABSTRACTS OF JAPAN vol. 13, no. 56 (C-566)(3404) 8 Février 1989 & JP-A-63 247 360**
- **PATENT ABSTRACTS OF JAPAN vol. 12, no. 479 (C-552)(3326) 14 Décembre 1988 & JP-A-63 195 259**
- **JAPANESE JOURNAL OF APPLIED PHYSICS vol. 20, no. 1, 1 Janvier 1981, TOKYO JAPAN pages L48 - L50 T. MITSUYU ET AL. 'high dielectric constant films of amorphous linbo3 prepared by sputtering deposition'**

## Description

L'invention a trait à un élément de cible pour pulvérisation cathodique. Elle se rapporte encore à un procédé de préparation dudit élément et concerne également des cibles, notamment cibles de grande surface, réalisées à partir de cet élément.

Le revêtement de matériaux divers par des couches minces à propriétés particulières connaît actuellement un développement considérable. On peut citer notamment le dépôt de couches anticorrosion sur les métaux, de couches antireflet sur les verres d'optique ou encore le dépôt de matériaux ultradurs sur des pièces mécaniques.

De nombreuses méthodes ont été proposées pour la réalisation de telles couches, lesdites méthodes dépendant, entre autres, de la nature du ou des composés générateurs de la couche de revêtement. Ainsi, lorsque lesdits composés générateurs sont gazeux, on peut faire appel aux diverses méthodes de dépôt chimique en phase vapeur assisté ou non par plasma. Avec des composés générateurs liquides ou susceptibles d'être mis en solution, on peut employer des méthodes électrochimiques, s'il s'agit de déposer une couche d'un métal, ou encore utiliser des méthodes telles que celles dites de dépôt à la tournette (en anglais "spin coating") ou de dépôt par pulvérisation d'un brouillard chaud (en anglais "hot spray").

Dans le cas où la source génératrice du revêtement est un matériau solide, la méthode la plus utilisée pour réaliser le revêtement est la pulvérisation cathodique. Dans une telle méthode, le matériau solide générateur du revêtement, que l'on désigne généralement par le vocable "matériau cible" ou "cible" et qui peut être constitué par un métal ou un alliage métallique ou bien encore consister en un composé chimique inorganique à point de fusion très élevé, par exemple une céramique ou un oxyde réfractaire, est bombardé par des ions ayant une énergie suffisante pour arracher des particules du matériau cible, lesdites particules se déposent sur l'objet à revêtir en formant sur ce dernier le revêtement recherché.

Pour des raisons d'homogénéité et de vitesse de croissance du dépôt formé des particules arrachées au matériau cible, il est nécessaire que la surface dudit matériau cible à déposer sur l'objet soit de taille suffisante. Dans le cas du revêtement d'objets de grande surface, vitrages par exemple, on est ainsi conduit à utiliser des cibles de grande surface, dont la surface est avantageusement plus grande que celle de l'objet à revêtir.

Si la fabrication de cibles de grande surface à partir de métaux ou d'alliages métalliques ne pose pas de problèmes, il n'en est plus de même lorsqu'il s'agit de matériaux du type des composés chimiques inorganiques à point de fusion élevé. En effet, pour de tels matériaux, la fabrication de la cible passe par la réalisation d'une céramique ou d'un produit fritté constitué desdits matériaux. La réalisation d'une céramique ou d'un produit fritté de grande surface nécessite la mise au point, au coup par coup, du procédé le plus approprié, une telle mise au point étant le plus souvent longue, difficile et par conséquent onéreuse et de plus elle doit être faite impérativement par un spécialiste.

Un élément de cible pour pulvérisation cathodique fait d'un composé inorganique à point de fusion supérieur à 300°C (oxyde mixte d'indium et d'étain), et fabriqué par moulage, est connu de EP-A-0 342 537.

Patent Abstracts of Japan, vol. 10, no. 287 (C-375) [2343], 30 septembre 1986, & JP-A-61 104 073, décrit, lui, une cible pour pulvérisation cathodique, cette cible comportant un élément de cible fixé à une électrode refroidie et en forme de plaque, une couche de mousse métallique épousant la forme irrégulière de l'élément de cible étant disposée entre l'élément et l'électrode pour assurer un bon contact thermique entre ceux-ci.

L'invention propose un élément de cible pour pulvérisation cathodique, qui permet de réaliser aisément des cibles de grande surface, ledit élément pouvant être obtenu par un procédé simple, rapide et peu coûteux qui peut être mis en oeuvre par des personnes n'ayant pas de compétences particulières dans l'art de la céramique ou du frittage.

L'élément de cible pour pulvérisation cathodique, qui fait l'objet de l'invention est décrit en revendication 1 et est constitué d'une couche d'un composé chimique inorganique à point de fusion supérieur à 300°C déposée sur une couche support consistant en une mousse ou un feutre métallique de telle sorte que la couche du composé inorganique pénètre, sur une partie au moins de son épaisseur, dans la couche support pour former avec cette dernière une couche composite, dans laquelle le composé inorganique et le support s'interpénètrent et dont l'épaisseur est inférieure ou égale à celle de la couche support.

Avantageusement, l'épaisseur e de la couche composite peut représenter 10% à 100% et de préférence 50% à 100% de l'épaisseur totale $e_s$ de la couche support, c'est-à-dire de la somme de l'épaisseur de la partie de la couche support imprégnée de composé inorganique et de l'épaisseur de la partie de la couche support exempte de composé inorganique.

En outre, l'épaisseur e de la couche composite peut représenter 10% à 100% et de préférence 20% à 80% de l'épaisseur totale $e_c$ de la couche où est présent le composé inorganique, c'est-à-dire de la somme de l'épaisseur de la partie de la couche de composé inorganique située hors du support et de l'épaisseur de la partie de la couche de composé inorganique contenue dans le support.

La mousse ou le feutre métallique utilisés comme support du composé inorganique est en un métal ou alliage métallique sensiblement inerte vis-à-vis dudit composé inorganique. A titre d'exemples non limitatifs de mousses ou feutres métalliques utilisables selon l'invention, on peut citer les mousses ou feutres d'or, de platine, de nickel, de titane ou de cuivre. La porosité de la mousse ou du feutre métallique peut varier assez largement et le plus souvent elle est supérieure à 90%.

Le composé inorganique de l'élément de cible peut être notamment un oxyde, un sulfure, un halogénure ou un oxyhalogénure métallique dont le point de fusion est supérieur à 300°C, ledit composé inorganique dérivant d'un ou plusieurs métaux qui peuvent être ou non des métaux de transition.

En particulier, le composé inorganique de l'élément de cible peut répondre à l'une ou l'autre des formules $E_\alpha^k Z_\beta^p$ et $M_x^q T_y^n Z_z^p$, dans lesquelles E représente un métal des groupes I à VIII du Tableau Périodique des Eléments, par exemple Fe, Cu, Co, Ni, Ti, Cr, Mo, Sn, W et In, M et T désignent chacun un métal différent des groupes I à VIII dudit Tableau Périodique, par exemple Li, Na, K, Ag, Cu et Tl pour M et Ni, Co, W, Mn, Fe, Cr, V et Ti pour T, Z est un élément choisi parmi oxygène, soufre, fluor et chlore, les symboles k, q, n et p désignent les degrés d'oxydation moyens des éléments E, M, T et Z respectivement, $\alpha$ et $\beta$ désignent des nombres entiers positifs tels que $\alpha k + \beta p = o$ et x, y et z désignent des nombres entiers positifs tels que $qx + ny + pz = O$.

Le terme degré d'oxydation moyen, appliqué à chaque élément, traduit le fait que l'élément concerné peut avoir plusieurs degrés d'oxydation dans le composé considéré.

Le composé inorganique peut être tout spécialement un oxyde et notamment un oxyde ayant l'une ou l'autre des formules $E_\alpha^k O_\beta^{2-}$ et $M_x^q T_y^n O_z^{2-}$, dans lesquelles E est un métal des groupes I à VIII du Tableau Périodique des Eléments, par exemple Fe, Cu, Co, Ni, W, Mo, Ti, Cr, Sn et In, M et T désignent chacun un métal différent dudit Tableau Périodique, par exemple Li, Na, K, Ag, Cu et Tl pour M et Ni, Co, W, Mn, Cr, Fe, V et Ti pour T, les symboles k, q et n désignant les degrés d'oxydation moyens de E, M et T respectivement, $\alpha$ et $\beta$ sont des nombres entiers positifs tels que $\alpha k - 2\beta = O$ et x, y et z désignent des nombres entiers positifs tels que $qx + ny - 2z = O$. Comme exemples de tels oxydes on peut citer à titre non limitatif $WO_3$, $MoO_3$, $Cr_2O_3$, $TiO_2$, $Fe_2O_3$, $Li_{2-v} NiO_2$ avec $0 \le v \le 1$, $LiCrO_2$, $LiFeO_2$, $LiWO_3$ et $Li_2WO_4$.

L'élément de cible selon l'invention peut être obtenu directement sous la forme d'un élément de cible de grande surface. On peut également produire des éléments de cible ayant une surface plus petite que la surface de la cible de grande surface à obtenir et assembler ensuite une pluralité de tels éléments de cible, comme il sera décrit plus loin, pour former un élément de cible de grande surface.

Un procédé pour la production d'un élément de cible selon l'invention, qu'il soit de grande surface ou de surface plus réduite, est décrit en revendication 10 et est tel que l'on applique un système précurseur du composé inorganique choisi sur un support formé d'une couche de mousse ou de feutre métallique, on soumet l'ensemble constitué du support revêtu de la couche de système précurseur du composé inorganique à une pression allant de 0,1 MPa à 15 MPa et de préférence de 0,1 MPa à 5 MPa, on porte l'ensemble résultant à une température comprise entre 300°C et 1600°C et de préférence entre 600°C et 1200°C et propre à conduire à un frittage dudit ensemble, ladite température étant inférieure à la température de fusion du support, et maintient ledit ensemble à la température atteinte pendant une durée suffisante pour obtenir un ensemble fritté, puis on refroidit l'ensemble fritté pour le ramener à température ambiante en réalisant ce refroidissement de manière à éviter tout phénomène de trempe.

Le système précurseur du composé inorganique peut consister en le composé inorganique lui même, comme c'est le cas notamment pour les composés précités de formule $E_\alpha^k Z_\beta^p$ et notamment pour les oxydes de formule $E_\alpha^k O_\beta^{2-}$ tels que ceux mentionnés précédemment. Le système précurseur du composé inorganique peut être également formé d'un mélange d'ingrédients conduisant, par réaction chimique aux températures mentionnées ci-dessus, au composé inorganique envisagé. Ainsi, lorsque le composé inorganique consiste en un composé de formule $M_x^q T_y^n Z_z^p$ et notamment en un oxyde de formule $M_x^q T_y^n O_z^{2-}$, le système précurseur du composé inorganique peut consister en un mélange, en proportions appropriées, d'un composé du métal M et d'un composé du métal T, qui sont susceptibles de réagir aux températures définies plus haut pour former le composé $M_x^q T_y^n Z_z^p$. Par exemple, lorsque le composé inorganique est un oxyde de formule $M_x^q T_y^n O_z^{2-}$, c'est-à-dire un oxyde mixte du type céramique, le mélange précurseur d'un tel oxyde peut consister avantageusement en un mélange d'un carbonate du métal M de formule $M_x^q (CO_3)_{\frac{qx}{2}}$ et d'un oxyde du métal T de formule

$$T_y^n O_{\frac{ny}{2}}^{2-}.$$

Ainsi, à partir d'un mélange précurseur renfermant des quantités équimoléculaires de $Li_2CO_3$ et NiO, de $Li_2CO_3$ et $Cr_2O_3$, de $Li_2CO_3$ et $Fe_2O_3$ ou de $Li_2CO_3$ et $WO_3$ on forme respectivement les composés inorganiques du type céramique de formules $Li_2NiO_2$, $LiCrO_2$, $LiFeO_2$ et $Li_2WO_4$.

Pour son application sur le support mousse ou feutre métallique, le système précurseur du composé inorganique peut se présenter sous la forme d'une poudre de granulométrie adaptée à la porosité du support. Dans ce cas, l'application du système précurseur du composé inorganique sur le support en mousse ou feutre métallique est effectuée par saupoudrage dudit support au moyen de la poudre.

On peut également réaliser une pâte d'enduction en mélangeant la poudre de système précurseur avec un ou plusieurs liquides tels que l'eau ou un liquide organique ou bien encore préparer un gel à partir du système précurseur pulvérulent suivant l'une quelconque des techniques conventionnelles sol/gel, puis enduire le support en mousse ou feutre métallique au moyen de ladite pâte ou dudit gel.

Comme déjà indiqué précédemment, la mousse ou le feutre métallique constituant le support est de préférence en un métal ou alliage métallique substantiellement inerte vis à vis du composé inorganique et de son système précurseur et, par exemple, en un métal tel que l'or, le platine, le titane, le cuivre ou le nickel.

Lorsque l'application du système précurseur du composé inorganique sur le support est réalisée par enduction au moyen de produits humides du type pâte ou gel, l'ensemble issu de l'enduction du support par la pâte ou le gel est avantageusement soumis à une étape de séchage jusqu'à l'obtention d'un produit sensiblement sec, avant d'être soumis à l'action de la pression (étape de compression).

La compression de l'ensemble formé du support revêtu du système précurseur du composé inorganique est réalisée de manière à conduire à un écrasement modéré du support en mousse ou feutre métallique. Avantageusement, ladite compression est telle que l'épaisseur de la couche de support après compression représente encore au moins 10% et de préférence au moins 50% de l'épaisseur initiale de ladite couche support.

Lorsque l'ensemble comprimé est porté à la température comprise entre 300°C et 1600°C, la vitesse de montée en température est avantageusement contrôlée pour éviter les chocs thermiques susceptibles de conduire, entre autres, à une fissuration de la couche superficielle du composé inorganique. Des vitesses de montée en température allant de 0,05°C à 30°C par minute et plus particulièrement de 0,1°C à 15°C par minute conduisent à des résultats satisfaisants.

De même, lors du refroidissement de l'ensemble depuis les températures entre 300°C et 1600°C jusqu'à la température ambiante, il faut éviter un refroidissement trop rapide susceptible d'entraîner une trempe de l'ensemble en cours de refroidissement. Avantageusement, on peut opérer avec des vitesses de refroidissement allant de 0,05°C à 30°C par minute et plus particulièrement de 0,1°C à 15°C par minute.

L'élément de cible selon l'invention est collé, côté support en mousse ou feutre métallique, sur un substrat métallique, par exemple un substrat en laiton, en aluminium, en titane, en cuivre, en tungstène, ou en acier inoxydable, au moyen d'un adhésif conducteur de la chaleur et de l'électricité, pour constituer une cible définie en revendication 24 et pouvant être montée dans un dispositif de pulvérisation cathodique.

Selon l'invention, on peut produire directement un élément de cible de grande surface, de l'ordre de 400cm$^2$ à 1m$^2$, et coller ledit élément, comme indiqué ci-dessus, sur un substrat métallique de surface correspondante pour produire une cible de grande surface.

On peut encore réaliser une cible de grande surface en produisant des éléments de cible selon l'invention ayant une surface plus petite que celle de la cible de grande surface à réaliser, puis en collant, comme indiqué plus haut, une pluralité desdits éléments de cible sur un substrat métallique de surface correspondant à celle de la cible de grande surface à produire, lesdits éléments de cible étant disposés sur le substrat de manière jointive pour couvrir sur ce substrat une surface correspondant à celle désirée pour la cible de grande surface.

Avantageusement, pour les cibles de petite, moyenne ou grande surface obtenues par collage, réalisé comme indiqué précédemment, d'un ou plusieurs éléments de cible sur un substrat métallique de surface appropriée, le substrat métallique présente une surface dont le contour entoure le contour de l'élément de cible unique ou de l'élément de cible résultant de la juxtaposition jointive d'éléments de cible de petite surface, lesdits contours étant de préférence parallèles entre eux, de manière à définir, sur la face du substrat métallique sur laquelle le ou les éléments de cible sont collés, une zone marginale entourant l'élément de cible. Dans cette zone marginale peuvent déboucher des orifices traversant le substrat métallique et destinés au passage d'organes de fixation, par exemple vis ou autres, permettant de fixer la cible sur un organe support appartenant au dispositif de pulvérisation cathodique.

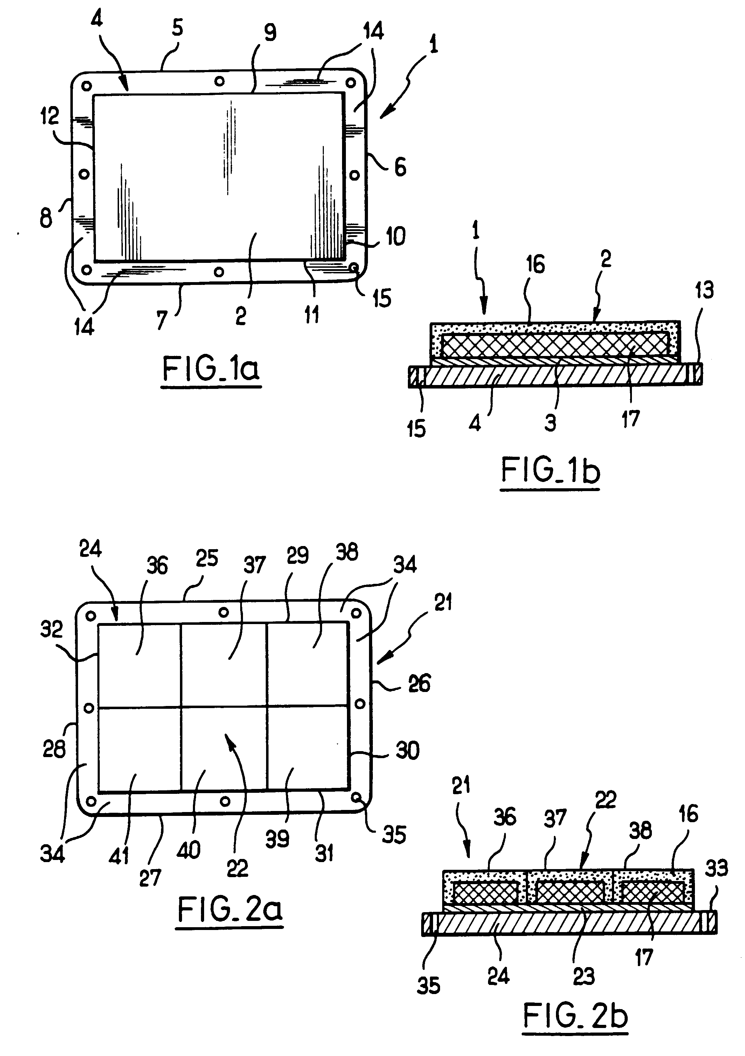

Sur le dessin annexé, les figures 1a et 1b montrent schématiquement une vue de dessus (figure 1a) et une coupe longitudinale (figure 1b) d'une cible de grande surface obtenue à partir d'un seul élément de cible ayant une grande surface et les figures 2a et 2b représentent schématiquement une vue de dessus (figure 2a) et une coupe longitudinale (figure 2b) d'une cible de grande surface obtenue à partir d'une pluralité d'éléments de cible de surface plus petite.

En se référant aux figures 1a et 1b, une cible 1 de grande surface comporte un élément de cible 2 de grande surface ayant la forme d'un rectangle, ledit rectangle ayant par exemple une longueur de 30cm et une largeur de 20cm. L'élément 2 est solidarisé par une couche 3 d'un adhésif conducteur de la chaleur et de l'électricité, par exemple une colle conductrice époxy bicomposante renfermant de l'argent, à un substrat métallique 4 ayant des dimensions légèrement supérieures à celles de l'élément rectangulaire 2 de telle sorte que le contour formé des bords 5 à 8 du substrat métallique rectangulaire 4 entoure le contour formé des bords 9 à 12 de l'élément rectangulaire de cible 2 et lui soit parallèle, de manière à définir sur la face 13 du substrat métallique sur laquelle l'élément 2 est collé, une zone marginale 14 entourant ledit élément 2. Dans cette zone marginale débouchent des orifices tels que 15 traversant le substrat métallique et destinés au passage d'organes de fixation, par exemple vis ou autres, permettant de monter la cible 1 sur un organe support appartenant au dispositif de pulvérisation cathodique. L'élément de cible 2 est un élément selon l'invention constitué d'une couche 16 d'un composé inorganique à point de fusion supérieur à 300°C, notamment céramique ou oxyde réfractaire, solidaire d'une couche composite 17 formée d'une mousse ou d'un feutre métallique et dudit composé inorganique de telle sorte que la mousse ou le feutre métallique et le composé inorganique s'interpénètrent dans toute l'épaisseur de ladite couche composite, la couche 16 pouvant revêtir également les chants de la couche composite 17.

En se référant aux figures 2a et 2b, une cible 21 de grande surface comporte un élément de cible 22 de grande surface, qui a la forme d'un rectangle, par exemple rectangle de 30cm de longueur et de 20cm de largeur, et résulte de la juxtaposition jointive de six éléments de cible 36 à 41 ayant chacun la forme d'un carré, par exemple de 10cm de côté. Les éléments de cible 36 à 41 qui constituent l'élément de cible 22 sont solidarisés par une couche 23 d'un adhésif conducteur de la chaleur et de l'électricité, par exemple une colle conductrice époxy bicomposante renfermant de l'argent, à un substrat métallique 24 ayant des dimensions légèrement supérieures à celles de l'élément rectangulaire 22 de telle sorte que le contour formé des bords 25 à 28 du substrat métallique 24 rectangulaire entoure le contour formé des bords 29 à 32 de l'élément rectangulaire 22 et lui soit parallèle, de manière à définir sur la face 33 du substrat métallique sur laquelle les éléments de cible 36 à 41 formant l'élément 22 sont collés, une zone marginale 34 entourant ledit élément 22. Dans cette zone marginale débouchent des orifices tels que 35 traversant le substrat métallique et destinés au passage d'organes de fixation, par exemple vis ou autres, permettant de monter la cible 21 sur un organe support appartenant à un dispositif de pulvérisation cathodique. Les éléments de cible 36 à 41, dont l'assemblage jointif conduit à l'élément 22 de grande surface, sont des éléments selon l'invention constitués chacun d'une couche 16 d'un composé inorganique à point de fusion supérieur à 300°C, notamment céramique ou oxyde réfractaire, solidaire d'une couche composite 17 formée d'une mousse ou d'un feutre métallique et dudit composé inorganique de telle sorte que la mousse ou le feutre métallique et le composé inorganique s'interpénètrent dans toute l'épaisseur de la couche composite, la couche 16 pouvant revêtir également les chants de la couche composite 17.

L'utilisation d'un support formé d'une mousse ou d'un feutre métallique, pour constituer les éléments de cible selon l'invention, permet d'obtenir aisément une bonne tenue mécanique de la cible.

L'invention est illustrée par les exemples suivants, donnés à titre non limitatif.

EXEMPLE 1 :

Elément de cible oxyde d'indium/oxyde d'étain et cible correspondante

Dans un mortier on plaçait 14g d'oxyde d'indium $In_2O_3$ et 1g d'oxyde d'étain $SnO_2$, lesdits oxydes étant sous la forme de poudres de granulométrie comprise entre 10µm et 100µm. Au contenu du mortier on ajoutait alors 10g d'eau, puis on mélangeait le tout jusqu'à l'obtention d'une pâte homogène. Une plaque en forme de carré de 10cm de côté était découpée dans une feuille de mousse d'or présentant une masse surfacique égale à 1 kg/m² et une épaisseur comprise entre 1,7 et 2mm et l'on enduisait l'une des faces de la plaque de mousse au moyen de la pâte précitée en utilisant une spatule pour effectuer cette enduction. Ladite enduction était poursuivie jusqu'à ce que la mousse ne fût plus apparente. L'ensemble résultant de l'enduction était alors soumis à une opération de séchage par maintien dans une étuve à 110°C pendant 1 heure. L'ensemble séché était ensuite placé sous une presse et comprimé à température ambiante sous cette presse pendant une minute sous l'action d'une pression égale à 1 MPa. L'ensemble comprimé était alors placé dans un four et soumis dans ce four à un traitement thermique comportant une montée de la température du four depuis la température ambiante jusqu'à 950°C avec une vitesse de 5°C/minute, puis un maintien de ladite température de 950°C pendant 6 heures et enfin un abaissement de la température du four de 950°C jusqu'à la température ambiante avec une vitesse de 5°C/minute. Les diverses opérations précitées étaient réalisées sous une atmosphère d'air atmosphérique (atmosphère ambiante).

A l'issue du traitement thermique, on obtenait un ensemble constituant l'élément de cible d'oxyde d'indium/oxyde d'étain et formé d'une couche d'oxyde mixte d'indium et d'étain, d'épaisseur égale à 2mm, solidaire d'une couche composite, d'épaisseur égale à 1mm, dans laquelle la mousse d'or et l'oxyde mixte d'indium et d'étain s'interpénètrent sur la totalité de l'épaisseur de la couche de mousse.

L'élément de cible, obtenu comme décrit ci-dessus, était collé sur un substrat d'acier inoxydable en forme de carré de 12cm de côté, à l'aide d'une colle conductrice époxy bicomposante à l'argent, de manière à laisser apparente, sur la face du substrat portant l'élément cible, une bande marginale de 1cm de largeur, dans laquelle on perçait des orifices pour le passage d'organes de fixation tels que des vis. On obtenait alors une cible ayant une structure comparable à celle schématisée sur les figures 1a et 1b, ladite cible ayant une surface utile (surface de l'élément de cible) de 100cm².

La cible ainsi réalisée a été utilisée en pulvérisation cathodique pour la production d'un dépôt mince transparent d'oxyde mixte d'indium et d'étain sur un support de verre, ledit dépôt étant utilisable dans divers systèmes électrochromes, notamment, comme électrode transparente. Le dépôt mince transparent obtenu avec cette cible a été analysé et l'on a noté l'absence d'or dans le dépôt, ce qui indique que la mousse servant de support à l'oxyde mixte n'apparaît pas à la surface.

## EXEMPLE 2 :

Eléments de cible oxyde d'indium/oxyde d'étain et cible correspondante de grande surface

En opérant comme décrit dans l'exemple 1, on préparait des éléments de cible d'oxyde d'indium/oxyde d'étain ayant chacun une surface de 100cm², lesdits éléments ayant la structure indiquée dans l'exemple 1.

Six éléments de cible ainsi obtenus étaient collés jointivement, côté mousse métallique, sur un substrat d'acier inoxydable en forme de rectangle de 34cm de longueur et 24cm de largeur, à l'aide d'une colle conductrice époxy bicomposante renfermant de l'argent, de manière à occuper sur le substrat une surface en forme de rectangle de 30cm de longueur et 20cm de largeur et à laisser apparente, sur la face du substrat portant les éléments de cible, une bande marginale de 2cm de largeur, dans laquelle on perçait des orifices pour le passage d'organes de fixation tels que des vis. On obtenait alors une cible de grande surface ayant une structure comparable à celle schématisée sur les figures 2a et 2b, ladite cible ayant une surface utile (surface occupée par l'ensemble des éléments de cible) de 600cm².

La cible ainsi réalisée a été utilisée en pulvérisation cathodique à courant continu pour la production d'un dépôt mince transparent d'oxyde mixte d'indium et d'étain sur un support en verre de grande surface. Le dépôt mince transparent obtenu ne renfermait pas de trace d'or.

## EXEMPLE 3 :

Elément de cible d'oxyde de tungstène et cible correspondante

On opérait comme décrit dans l'exemple 1, en remplaçant toutefois les oxydes d'indium et d'étain par de l'oxyde de tungstène $WO_3$ sous la forme d'une poudre de granulométrie comprise entre 10µm et 100µm, ledit oxyde étant employé en quantité égale à 10g, et en utilisant seulement 5g d'eau pour former la pâte d'oxyde de tungstène.

A l'issue du traitement thermique, on obtenait un ensemble constituant l'élément de cible d'oxyde de tungstène et formé d'une couche d'oxyde de tungstène $WO_3$, d'épaisseur égale à 2mm, solidaire d'une couche composite, d'épaisseur égale à 1mm, dans laquelle la mousse d'or et $WO_3$ s'interpénètrent sur la totalité de l'épaisseur de la couche de mousse.

L'élément de cible ci-dessus était collé, côté mousse, comme décrit dans l'exemple 1 sur un substrat de tungstène en forme de carré de 12cm de côté. On obtenait alors une cible ayant une structure comparable à celle schématisée sur les figures 1a et 1b, ladite cible ayant une surface utile de 100cm².

## EXEMPLE 4 :

Elément de cible d'oxyde mixte de lithium et nickel et cible correspondante

Dans un mortier on plaçait 3,7g de carbonate de lithium $Li_2CO_3$ et 7,5g d'oxyde de nickel NiO, lesdits carbonate et oxyde se présentant sous la forme de poudres de granulométrie comprise entre 10µm et 100µm, et l'on mélangeait le tout jusqu'à obtenir un produit homogène.

Une plaque en forme de carré de 10cm de côté était découpée dans une feuille de mousse de cuivre présentant une masse surfacique égale à 0,5kg/m² et une épaisseur d'environ 2mm et l'on dispersait le mélange pulvérulent de $Li_2CO_3$ et de NiO sur l'une des faces de la plaque de mousse. L'ensemble résultant était ensuite placé sous une presse et comprimé à température ambiante sous cette presse pendant cinq minutes sous l'action d'une pression égale à 1,5 MPa. L'ensemble comprimé était alors placé dans un four et était soumis dans ce four à un traitement thermique comportant une montée de la température du four depuis la température ambiante jusqu'à 400°C avec une vitesse de 10°C par minute, puis un maintien de ladite température pendant 6 heures pour décomposer complètement le carbonate de lithium, ensuite une montée de la température du four jusqu'à 850°C avec une vitesse de 10°C/minute puis maintien de ladite température pendant 6 heures et enfin un abaissement de la température du four de 850°C jusqu'à la température ambiante avec une vitesse de 10°C/minute environ. Les diverses opérations précitées étaient réalisées sous une atmosphère d'air atmosphérique.

A l'issue du traitement thermique, on obtenait un ensemble constituant l'élément de cible d'oxyde mixte de lithium et de nickel de formule $Li\,Ni\,O_2$, ledit ensemble étant formé d'une couche d'oxyde mixte $Li\,NiO_2$, d'épaisseur égale à 2mm, solidaire d'une couche composite, d'épaisseur égale à 1mm, dans laquelle la mousse de cuivre et l'oxyde mixte $Li\,NiO_2$ s'interpénètrent sur la totalité de la couche de mousse.

L'élément de cible obtenu était collé, côté mousse, comme décrit dans l'exemple 1 sur un substrat de laiton en forme de carré de 12 cm de côté. On obtenait alors une cible ayant une structure comparable à celle schématisée sur les figures 1a et 1b, ladite cible ayant une surface utile de 100cm².

La cible ainsi réalisée a été utilisée en pulvérisation cathodique à courant continu pour la production d'un dépôt mince d'oxyde mixte de lithium et de nickel sur un substrat. Le dépôt mince obtenu ne renfermait pas de trace de cuivre, ce qui indique que la mousse servant de support n'apparaît pas à la surface de l'élément cible.

EXEMPLE 5 :

Elément de cible d'oxyde mixte de lithium et de chrome et cible correspondante

On opérait comme décrit dans l'exemple 4, en remplaçant toutefois l'oxyde de nickel par 7,6g d'oxyde de chrome $Cr_2O_3$ et la mousse de cuivre par une mousse de nickel de masse surfacique égale à 0,5 kg/m$^2$ et d'épaisseur 2mm environ.

A l'issue du traitement thermique, on obtenait un ensemble constituant l'élément de cible d'oxyde mixte de lithium et de chrome, ledit ensemble étant formé d'une couche d'oxyde mixte de lithium et de chrome, d'épaisseur égale à 3mm, solidaire d'une couche composite, d'épaisseur égale à 1mm, dans laquelle la mousse de nickel et l'oxyde mixte de lithium et de chrome s'interpénètrent dans toute l'épaisseur de la couche de mousse.

L'élément de cible obtenu était collé, côté mousse, comme indiqué dans l'exemple 1 sur une plaque de laiton en forme de carré de 12cm de côté. On obtenait alors une cible ayant une structure comparable à celle schématisée sur les figures 1a et 1b, ladite cible ayant une surface utile de 100cm$^2$.

La cible ainsi réalisée a été utilisée en pulvérisation cathodique pour la production d'un dépôt mince d'oxyde mixte de lithium et de chrome sur un substrat. Le dépôt mince obtenu ne renfermait pas de trace de nickel, ce qui indique que la mousse servant de support n'apparaît pas à la surface de l'élément de cible.

EXEMPLE 6 :

Elément de cible d'oxyde mixte de lithium et de fer et cible correspondante

On opérait comme décrit dans l'exemple 4 avec toutefois les modifications suivantes :

. on utilisait 8g d'oxyde de fer $Fe_2O_3$ à la place de l'oxyde de nickel,
. on remplaçait la mousse de cuivre par une mousse d'or ayant une masse surfacique de 1kg/m$^2$ et une épaisseur de 2mm environ, et
. on portait la température du four, après décomposition du carbonate de lithium, à la valeur de 950°C.

A l'issue du traitement thermique, on obtenait un ensemble constituant l'élément de cible d'oxyde mixte de lithium et de fer, ledit ensemble étant formé d'une couche d'oxyde mixte de lithium et de fer, d'épaisseur égale à 2,5mm, solidaire d'une couche composite, d'épaisseur égale à 1mm, dans laquelle la mousse d'or et l'oxyde mixte de lithium et de fer s'interpénètrent sur toute l'épaisseur de la couche de mousse.

L'élément de cible obtenu était collé, côté mousse, comme indiqué dans l'exemple 1 sur une plaque d'aluminium en forme de carré de 12 cm de côté. On obtenait alors une cible ayant une structure comparable à celle schématisée sur les figures 1a et 1b, ladite cible ayant une surface utile de 100cm$^2$.

La cible ainsi réalisée a été utilisée en pulvérisation cathodique pour la production d'un film mince d'oxyde mixte de lithium et de fer. Le film mince obtenu ne renfermait pas de trace d'or.

EXEMPLE 7 :

Eléments de cible d'oxyde mixte de lithium et de tungstène et cibles correspondantes :

On effectuait deux essais (A et B) de production d'éléments de cible d'oxyde mixte de lithium et de tungstène en opérant comme décrit dans l'exemple 5, mais en remplaçant toutefois le mélange de carbonate de lithium et d'oxyde de chrome par un mélange pulvérulent ayant une granulométrie comprise en 10µm et 100µm et renfermant 3,7g de carbonate de lithium et 46g de $WO_3$ dans le cas de l'essai A et 7,4g de carbonate de lithium et 46g de $WO_3$ dans le cas de l'essai B.

A l'issue du traitement thermique, on obtenait des ensembles constituant les éléments de cible d'oxyde mixte de lithium et de tungstène, lesdits ensembles étant formés, chacun, d'une couche d'oxyde mixte de lithium et de tungstène, d'épaisseur égale à 2mm (essai A) ou 2,5mm (essai B), solidaire d'une couche composite, d'épaisseur égale à lmm (essai A et essai B), dans laquelle la mousse de nickel et l'oxyde mixte de lithium et de tungstène s'interpénètrent et dont l'épaisseur représente la totalité de l'épaisseur de la couche de mousse. Chacun des éléments de cible obtenus était collé, côté mousse, comme indiqué dans l'exemple 1 sur une plaque de tungstène en forme de carré de 12cm de côté. On obtenait des cibles ayant une structure comparable à celle schématisée sur les figures 1a et 1b, lesdites cibles ayant une surface utile de 100cm$^2$.

**Revendications**

1. Elément de cible (2,22) pour pulvérisation cathodique constitué d'une couche (16) d'un composé chimique inorganique à point de fusion supérieur à 300°C déposée sur une couche support consistant en une mousse ou un feutre métallique, la couche du composé inorganique pénètrant, sur une partie au moins de son épaisseur, dans la couche support et formant avec cette dernière une couche composite (17), dans laquelle le composé inorganique et le support s'interpénètrent et dont l'épaisseur est inférieure ou égale à celle de la couche support.

2. Elément de cible selon la revendication 1, caractérisé en ce que l'épaisseur (e) de la couche composite représente 10% à 100% et de préférence 50% à 100% de l'épaisseur totale ($e_s$) de la couche support.

3. Elément de cible selon la revendication 1 ou 2, caractérisé en ce que l'épaisseur (e) de la couche composite représente 10% à 100% et de préférence 20% à 80% de l'épaisseur totale ($e_c$) de la couche où est présent le composé inorganique.

4. Elément de cible selon l'une des revendications 1 à 3, caractérisé en ce que la mousse ou le feutre métallique utilisés comme support du composé inorganique est en un métal ou alliage métallique sensiblement inerte vis-à-vis dudit composé inorganique.

5. Elément de cible selon l'une des revendications 1 à 3, caractérisé en ce que le support du composé inorganique est en une mousse ou un feutre d'or, de platine, de nickel, de titane ou de cuivre.

6. Elément de cible selon l'une des revendications 1 à 5, caractérisé en ce que la mousse ou le feutre métallique a une porosité supérieure à 90%.

7. Elément de cible selon l'une des revendications 1 à 6, caractérisé en ce que le composé inorganique est un oxyde, un sulfure, un halogénure ou un oxyhalogénure métallique dont le point de fusion est supérieur à 300°C, ledit composé inorganique dérivant d'un ou plusieurs métaux qui sont ou non des métaux de transition.

8. Elément de cible selon l'une des revendications 1 à 6, caractérisé en ce que le composé inorganique répond à l'une ou l'autre des formules $E_\alpha^k Z_\beta^p$ et $M_x^q T_y^n Z_z^p$, dans lesquelles E représente un métal des groupes I à VIII du Tableau Périodique des Eléments, par exemple Fe, Cu, Co, Ni, Ti, Cr, Mo, W, Sn et In, M et T désignent chacun un métal différent des groupes I à VIII dudit Tableau Périodique, par exemple Li, Na, K, Ag, Cu et Tl pour M et Ni, Co, W, Mn, Fe, Cr, V et Ti pour T, Z est un élément choisi parmi oxygène, soufre, fluor et chlore, les symboles k, q, n et p désignent les degrés d'oxydation moyens des éléments E, M, T et Z respectivement, $\alpha$ et $\beta$ désignent des nombres entiers positifs tels que $\alpha k + \beta p = o$ et x, y et z désignent des nombres entiers positifs tels que $qx + ny + pz = o$.

9. Elément de cible selon l'une des revendications 1 à 6, caractérisé en ce que le composé inorganique est un oxyde et notamment un oxyde répondant à l'une ou l'autre des formules $E_\alpha^k O_\beta^{2-}$ et $M_x^q T_y^n O_z^{2-}$, dans lesquelles E est un métal des groupes I à VIII du Tableau Périodique des Eléments, par exemple Fe, Cu, Co, Ni, W, Mo, Ti, Cr, Sn et In, M et T désignent chacun un métal différent dudit Tableau Périodique, par exemple Li, Na, K, Ag, Cu et Tl pour M et Ni, Co, W, Mn, Cr, Fe, V et Ti pour T, les symboles k, q et n désignant les degrés d'oxydation moyens de E, M et T respectivement, $\alpha$ et $\beta$ sont des nombre entiers positifs tels que $\alpha k - 2\beta = o$ et x, y et z désignent des nombres entiers positifs tels que $qx + ny - 2z = o$.

10. Procédé de préparation d'un élément de cible selon la revendication 1, tel que l'on applique un système précurseur d'un composé inorganique à point de fusion supérieur à 300°C sur un support formé d'une couche de mousse ou de feutre métallique, on soumet l'ensemble constitué du support revêtu de la couche de système précurseur du composé inorganique à une pression allant de 0,1 MPa à 15 MPa, on porte l'ensemble résultant à une température comprise entre 300°C et 1600°C et propre à conduire à un frittage dudit ensemble, ladite température étant inférieure à la température de fusion du support, et maintient l'ensemble à la température atteinte pendant une durée suffisante pour obtenir un ensemble fritté, puis on refroidit l'ensemble fritté pour le ramener à température ambiante en réalisant ce refroidissement de manière à éviter tout phénomène de trempe.

11. Procédé selon la revendication 10, caractérisé en ce que la pression à laquelle est soumis l'ensemble formé du support revêtu de la couche de système précurseur du composé inorganique va de 0,1 MPa à 5 MPa.

12. Procédé selon la revendication 10 ou 11, caractérisé en ce que la température à laquelle est porté et maintenu l'ensemble après l'action de la pression est comprise entre 600°C et 1200°C.

13. Procédé selon l'une des revendications 10 à 12, caractérisé en ce que le système précurseur du composé inorganique renferme le composé inorganique lui même, ledit composé étant en particulier un composé de formule $E_\alpha^k Z_\beta^p$, dans laquelle E représente un métal des groupes I à VIII du Tableau Périodique des Eléments, par exemple Fe, Cu, Co, Ni, Ti, Cr, Mo, W, Sn et In, Z est un élément choisi parmi oxygène, soufre, fluor et chlore, les symboles k et p désignent les degrés d'oxydation moyens des éléments E et Z respectivement et $\alpha$ et $\beta$ sont des nombres entiers positifs tels que $\alpha k + \beta p = o$.

14. Procédé selon l'une des revendications 10 à 12, caractérisé en ce que le système précurseur du composé inorganique renferme le composé inorganique lui même, ledit composé étant un oxyde et notamment un oxyde de formule $E_\alpha^k O_\beta^{2-}$, dans laquelle E est un métal des groupes I à VIII du Tableau Périodique des Eléments, par exemple Fe, Cu, Co, Ni, W, Mo, Ti, Cr, Sn et In, le symbole k désigne le degré d'oxydation moyen du métal E et $\alpha$ et $\beta$ sont des nombres entiers positifs tels que $\alpha k - 2\beta = o$.

15. Procédé selon l'une des revendications 10 à 12, caractérisé en ce que le système précurseur du composé inorganique est formé d'un mélange d'ingrédients conduisant, par réaction chimique aux températures choisies pour le frittage, au composé inorganique désiré.

16. Procédé selon la revendication 15, caractérisé en ce que le composé inorganique est un composé de formule $M_x^q \, T_y^n \, Z_z^p$, dans laquelle M et T désignent chacun un métal différent des groupes I à VIII du Tableau Périodique des Eléments, par exemple Li, Na, K, Ag, Cu et Tl pour M et Ni, Co, W, Mn, Fe, Cr, V et Ti pour T, Z est un élément choisi parmi oxygène, soufre, fluor et chlore, les symboles q, n et p désignent les degrés d'oxydation moyens des éléments M, T et Z respectivement et x, y et z désignent des nombres entiers positifs tels que $qx + ny + pz = o$ et en ce que le système précurseur du composé inorganique consiste en un mélange, en proportions appropriées, d'un composé du métal M et d'un composé du métal T, qui réagissent aux températures entre 300°C et 1600°C pour former le composé $M_x^q \, T_y^n \, Z_z^p$.

17. Procédé selon la revendication 16, caractérisé en ce que le composé inorganique est un oxyde et notamment un oxyde de formule $M_x^q \, T_y^n \, O_z^{2-}$, dans laquelle M, T, q et n ont les significations données dans la revendication 16 et x, y et z sont des nombres entiers positifs tels que $qx + ny - 2z = o$, et en ce que le système précurseur dudit composé inorganique consiste en un mélange d'un carbonate du métal M de formule $M_x^q \, (CO_3)_{\frac{qx}{2}}$ et d'un oxyde

$$T_y^n \, O_{\frac{ny}{2}}^{2-}$$

du métal T.

18. Procédé selon l'une des revendications 10 à 17, caractérisé en ce que le système précurseur du composé inorganique se présente sous la forme d'une poudre de granulométrie adaptée à la porosité du support et en ce que l'application du système précurseur sur le support est effectué par saupoudrage dudit support au moyen de ladite poudre.

19. Procédé selon l'une des revendications 10 à 17, caractérisé en ce que le système précurseur du composé inorganique se présente sous la forme d'une pâte d'enduction, obtenue en mélangeant le système précurseur en poudre avec un ou plusieurs liquides tels que l'eau ou un liquide organique, ou bien sous la forme d'un gel, obtenu à partir du système précurseur pulvérulent par une technique sol/gel, et en ce que l'application du système précurseur sur le support est effectuée par enduction au moyen de ladite pâte ou dudit gel.

20. Procédé selon la revendication 19, caractérisé en ce que l'ensemble issu de l'enduction du support par la pâte ou le gel est soumis à une étape de séchage jusqu'à obtenir un produit sensiblement sec, avant d'être soumis à l'action de la pression.

21. Procédé selon l'une des revendications 10 à 20, caractérisé en ce que l'action de la pression sur l'ensemble formé du support revêtu du système précurseur du composé inorganique est réalisée de telle sorte que l'épaisseur de la couche support après ladite action représente encore au moins 10% et de préférence au moins 50% de l'épaisseur initiale de ladite couche support.

22. Procédé selon l'une des revendications 10 à 21, caractérisé en ce que l'ensemble soumis à l'action de la pression est ensuite porté à la température comprise entre 300°C et 1600°C avec une vitesse allant de 0,05°C à 30°C par minute et de préférence de 0,1°C à 15°C par minute.

23. Procédé selon l'une des revendications 10 à 22, caractérisé en ce que le refroidissement de l'ensemble fritté depuis la température comprise entre 300°C et 1600°C jusqu'à la température ambiante est réalisé avec une vitesse allant de 0,05°C à 30°C par minute et de préférence de 0,1°C à 15°C par minute.

24. Cible pour pulvérisation cathodique consistant en un élément de cible (2,22) selon l'une des revendications 1 à 9 collé, côté support, sur un substrat métallique (4,24), par exemple substrat en laiton, aluminium, cuivre, titane, tungstène, ou acier inoxydable, au moyen d'un adhésif (3,23) conducteur de la chaleur et de l'électricité, notamment un adhésif consistant en une colle conductrice époxy bicomposante renfermant de l'argent.

25. Cible selon la revendication 24, caractérisée en ce qu'elle consiste en un élément de cible (2) d'une surface de l'ordre de 400 cm$^2$ à 1 m$^2$ collé sur un substrat métallique (4) de surface correspondante.

26. Cible selon la revendication 24, caractérisée en ce qu'elle se présente sous la forme d'une cible d'une surface de l'ordre de 400 cm$^2$ à 1 m$^2$, consistant en une pluralité d'éléments de cible (36,37,38) de surface inférieure à celle de ladite cible, qui sont collés sur un substrat métallique (24) de surface correspondant à celle de la cible en étant disposés sur ledit substrat de manière jointive, et couvrant sur ce substrat une surface correspondant à la surface désirée pour la cible .

27. Cible selon l'une des revendications 24 à 26, caractérisée en ce que le substrat métallique (4,24) présente une surface dont le contour entoure le contour de l'élément de cible unique (2) ou de l'élément de cible (22) résultant de la juxtaposition jointive d'éléments de cible (36,37,38) de petite surface, lesdits contours étant de préférence parallèles entre eux, une zone marginale (14,34) entourant l'élément de cible (2,22) étant ainsi définie sur la face du substrat métallique sur laquelle le ou les éléments de cible sont collés.

28. Cible selon la revendication 27, caractérisée en ce que dans ladite zone marginale (14,34) débouchent des orifices (15,35) traversant le substrat métallique et destinés au passage d'organes de fixation permettant de fixer la cible à un organe support appartenant à un dispositif de pulvérisation cathodique.

**Patentansprüche**

1. Targetelement (2,22) für die Kathodenzerstäubung, bestehend aus einer Schicht (16) einer anorganischen chemischen Verbindung mit einem Schmelzpunkt von über 300°C, die auf eine Trägerschicht abgelegt ist, die aus einem Metallschwamm oder -filz besteht, wobei die Schicht der anorganischen Verbindung wenigstens in einem Teil ihrer Dicke die Trägerschicht durchdringt und mit dieser eine Verbundstoffschicht (17) bildet, in der die anorganische Schicht und die Trägerschicht sich gegenseitig durchdringen und deren Dicke geringer ist als diejenige der Trägerschicht oder ihrer Dicke entspricht.

2. Targetelement nach Anspruch 1, dadurch gekennzeichnet, daß die Dicke (e) der Verbundstoffschicht 10 % bis 100 % und vorzugsweise 50 % bis 100 % der Gesamtdicke ($e_s$) der Trägerschicht ausmacht.

3. Targetelement nach Anspruch 1 oder 2, dadurch gekennzeichnet, daß die Dicke (e) der Verbundstoffschicht 10 % bis 100 % und vorzugsweise 20 % bis 80 % der Gesamtdicke ($e_c$) der Schicht, in der die anorganische Verbindung vorliegt, ausmacht.

4. Targetelement nach einem der Ansprüche 1 bis 3, dadurch gekennzeichnet, daß der als Träger für die anorganische Verbindung verwendete Metallschwamm oder -filz aus einem Metall oder einer Metallegierung, die gegenüber der anorganischen Verbindung praktisch inert ist, besteht.

5. Targetelement nach einem der Ansprüche 1 bis 3, dadurch gekennzeichnet, daß der Träger der anorganischen Verbindung aus einem Schwamm oder einem Filz aus Gold, Platin, Nickel, Titan oder Kupfer besteht.

6. Targetelement nach einem der Ansprüche 1 bis 5, dadurch gekennzeichnet, daß der Metallschwamm oder -filz eine Porosität von über 90 % aufweist.

7. Targetelement nach einem der Ansprüche 1 bis 6, dadurch gekennzeichnet, daß die anorganische Verbindung ein Metalloxid, -sulfid, -halogenid oder -oxyhalogenid ist, deren Schmelzpunkt über 300°C liegt, wobei die anorganische Verbindung von einem oder mehreren Metallen stammt, die gegebenenfalls Übergangsmetalle sind.

8. Targetelement nach einem der Ansprüche 1 bis 6, dadurch gekennzeichnet, daß die anorganische Verbindung einer der Formeln $E_\alpha^k Z_\beta^p$ und $M_x^q T_y^n Z_z^p$ entspricht, in denen E ein Metall der Gruppen I bis VIII des Periodensystems der Elemente wie z.B. Fe, Cu, Co, Ni, Ti, Cr, Mo, W, Sn und In darstellt, M und T jeweils ein anderes Metall der Gruppen I bis VIII des Periodensystems wie z.B. Li, Na, K, Ag, Cu und Tl für M und Ni, Co, W, Mn, Fe, Cr, V und Ti für T bezeichnen und Z ein Element, ausgewählt unter Sauerstoff, Schwefel, Fluor und Chlor, ist, die Symbole k, q, n und p die mittleren Oxidationsstufen der Elemente E, M, T bzw. Z bedeuten und $\alpha$, $\beta$, x, y, und z solche ganze positive Zahlen darstellen, daß die Beziehungen $\alpha k + \beta p = 0$ und $qx+ny+pz = 0$ gelten .

9. Targetelement nach einem der Ansprüche 1 bis 6, dadurch gekennzeichnet, daß die anorganische Verbindung ein Oxid und insbesondere ein Oxid einer der Formeln $E_\alpha^k O_\beta^{2-}$ und $M_x^q T_y^n O_z^{2-}$ darstellt, in welchen E ein Metall der Gruppen I bis VIII des Periodensystems der Elemente wie z.B. Fe, Cu, Co, Ni, W, Mo, Ti, Cr, Sn und In bedeutet, M und T jeweils ein anderes Metall der Gruppen I bis VIII des Periodensystems wie z.B. Li, Na, K, Ag, Cu und Tl für M und Ni, Co, W, Mn, Cr, Fe, V und Ti für T bezeichnen, die Symbole k, q und n die mittleren Oxidationsstufen von E, M bzw. T bedeuten, und $\alpha$, $\beta$, x, y, und z solche ganze positive Zahlen darstellen, daß die Beziehungen $\alpha k-2\beta = 0$ und $qx+ny-2z = 0$ gelten .

10. Verfahren zur Herstellung eines Targetelements nach Anspruch 1, bei dem man ein Vorstufensystem einer anorganischen Verbindung mit einem Schmelzpunkt von über 300°C auf einem aus einer Schicht aus einem Metallschwamm oder -filz gebildeten Träger aufbringt, den aus dein mit der Schicht des Vorstufensystems der anorganischen Verbindung überzogenen Träger bestehenden Körper mit einem Druck von 0,1 MPa bis 15 MPa beaufschlagt, den erhaltenen Körper auf eine Temperatur zwischen 300°C und 1600°C, die für das Sintern des Körpers geeignet ist, erwärmt, wobei diese Temperatur unterhalb der Schmelztemperatur des Trägers liegt, den Körper bei der erreichten Temperatur solange hält, bis man zu einem gesinterten Körper gelangt, und dann diesen auf Umgebungstemperatur so abkühlt, daß ein Abschrecken verhindert wird.

11. Verfahren nach Anspruch 10, dadurch gekennzeichnet, daß der Druck, mit dem der Körper beaufschlagt wird, der aus dem Träger gebildet wurde, der mit der Schicht des Vorstufensystems der anorganischen Verbindung überzogen worden ist, zwischen 0,1 MPa und 5 MPa liegt.

12. Verfahren nach einem der Ansprüche 10 oder 11, dadurch gekennzeichnet, daß die Temperatur, auf die der Körper nach Druckbeaufschlagung erwärmt und gehalten wird zwischen 600°C und 1200°C liegt.

13. Verfahren nach einem der Ansprüche 10 bis 12, dadurch gekennzeichnet, daß das Vorstufensystem der anorganischen Verbindung die anorganische Verbindung als solche enthält, wobei diese Verbindung insbesondere eine Verbindung der Formel $E_\alpha^k Z_\beta^p$ ist, in der E ein Metall der Gruppen I bis VIII des Periodensystems der Elemente wie z.B. Fe, Cu, Co, Ni, Ti, Cr, Mo, W, Sn und In bedeutet, Z ein Element, ausgewählt unter Sauerstoff, Schwefel, Fluor und Chlor, ist, die Symbole k und p die mittleren Oxidationsstufen der Elemente E bzw. Z bezeichnen und $\alpha$ und $\beta$ solche ganze positive Zahlen darstellen, daß die Beziehung $\alpha k + \beta p = 0$ gilt .

14. Verfahren nach einem der Ansprüche 10 bis 12, dadurch gekennzeichnet, daß das Vorstufensystem der anorganischen Verbindung die anorganische Verbindung als solche enthält, wobei diese Verbindung ein Oxid und insbesondere ein Oxid der Formel $E_\alpha^k O_\beta^{2-}$ ist, in welcher E ein Metall der Gruppen I bis VIII des Periodensystems der Elemente wie z. B. Fe, Cu, Co, Ni, W, Mo, Ti, Cr, Sn und In ist, das Symbol k die mittlere Oxidationsstufe des Metalls E bezeichnet und $\alpha$ und $\beta$ solche ganze positive Zahlen darstellen, daß die Beziehung $\alpha k - 2\beta = 0$ gilt .

15. Verfahren nach einem der Ansprüche 10 bis 12, dadurch gekennzeichnet, daß das Vorstufensystem der anorganischen Verbindung aus einem Komponentengemisch gebildet wird, das durch chemische Umsetzung bei den für das Sintern gewählten Temperaturen zur gewünschten anorganischen Verbindung führt.

16. Verfahren nach Anspruch 15, dadurch gekennzeichnet, daß die anorganische Verbindung eine Verbindung der Formel $M_x^q T_y^n Z_z^p$ ist, in welcher M und T jeweils ein anderes Metall der Gruppen I bis VIII des Periodensystems der Elemente wie z.B. Li, Na, K, Ag, Cu und Tl für M und Ni, Co, W, Mn, Fe, Cr, V und Ti für T bedeuten, Z ein Element, ausgewählt unter Sauerstoff, Schwefel, Fluor und Chlor, ist, die Symbole q, n und p die mittleren Oxidationsstufen der Elemente M, T bzw. Z bezeichnen und x, y und z solche ganze positive Zahlen darstellen, daß die Beziehung $qx+ny+pz = 0$ gilt, und daß das Vorstufensystem der anorganischen Verbindung aus einem Gemisch in geeigneten Mengenverhältnissen einer Verbindung des Metalls M und einer Verbindung des Metalls T besteht, die bei Temperaturen zwischen 300°C und 1600°C reagieren, um die Verbindung $M_x^q T_y^n Z_z^p$ zu bilden .

17. Verfahren nach Anspruch 16, dadurch gekennzeichnet, daß die anorganischen Verbindung ein Oxid und insbesondere ein Oxid der Formel $M_x^q T_y^n O_z^{2-}$ ist, in welcher M, T, q und n die in Anspruch 16 angegebenen Bedeutungen haben und x, y und z solche ganze positive Zahlen darstellen, daß die Beziehung $qx+ny-2z = 0$ gilt, und daß das Vorstufensystem der anorganischen Verbindung aus einem Gemisch aus einem Carbonat des Metalls M der Formel $M_x^q (CO_3)_{\frac{qx}{2}}$ und einem Oxid

$$T_y^n O_{\frac{ny}{2}}^{2-}$$

des Metalls T besteht .

18. Verfahren nach einem der Ansprüche 10 bis 17, dadurch gekennzeichnet, daß das Vorstufensystem der anorganischen Verbindung in Form eines Pulvers mit einer der Porosität des Trägers angepaßten Granulometrie vorliegt und die Aulbringung des Vorstufensystems auf den Träger durch Bepudern des Trägers mit dem Pulver erfolgt.

19. Verfahren nach einem der Ansprüche 10 bis 17, dadurch gekennzeichnet, daß das Vorstufensystem der anorganischen Verbindung in Form einer Streichmasse, die man durch Mischen des Vorstufensystems in Pulverform mit einer oder mehreren Flüssigkeiten wie Wasser oder einer organischen Flüssigkeit erhält, oder in Form eines Gels, das man aus einem pulverförmigen Vorstufensystem durch eine Sol-Gel-Technik erhält, vorliegt und daß die Aufbringung des Vorstufensystems auf den Träger durch Bestreichen mit der Masse oder dem Gel erfolgt.

20. Verfahren nach Anspruch 19, dadurch gekennzeichnet, daß der durch Bestreichen des Trägers mit der Masse oder dem Gel erhaltene Körper solange getrocknet wird, bis man zu einem praktisch trockenen Produkt gelangt, wonach es dann mit Druck beaufschlagt wird.

21. Verfahren nach einem der Ansprüche 10 bis 20, dadurch gekennzeichnet, daß die Druckbeaufschlagung des Körpers, der aus dem mit dem Vorstufensystem der anorganischen Verbindung überzogenen Träger gebildet wurde, so durchgeführt wird, daß die Dicke der Trägerschicht nach der Druckbeaufschlagung noch wenigstens 10 % und vorzugsweise noch wenigstens 50 %, der Ausgangsdicke der Trägerschicht ausmacht.

22. Verfahren nach einem der Ansprüche 10 bis 21, dadurch gekennzeichnet, daß der mit Druck beaufschlagte Körper dann auf eine Temperatur zwischen 300°C und 1600°C mit einer Geschwindigkeit von 0,05°C bis 30°C/min und vorzugweise von 0,1°C bis 15°C/min erwärmt wird.

23. Verfahren nach einem der Ansprüche 10 bis 22, dadurch gekennzeichnet, daß die Abkühlung des gesinterten Körpers von einer Temperatur zwischen 300°C und 1600°C auf Umgebungstemperatur mit einer Geschwindigkeit von 0,05°C bis 30°C/min und vorzugsweise von 0,1°C bis 15°C/min erfolgt.

24. Target für die Kathodenzerstäubung, bestehend aus einem Targetelement (2,22) nach einem der Ansprüche 1 bis 9, das trägerseitig auf ein Metallsubstrat (4,24) wie z.B. auf ein Substrat aus Messing, Aluminium, Kupfer, Titan, Wolfram oder nichtrostendem Stahl mit Hilfe eines wärme- und elektroleitfähigen Klebstoffs (3,23), insbesondere eines Klebstoffs aufgeklebt ist, der in einem Silber enthaltenden, leitenden Epoxid-Zweikomponentenkleber besteht.

25. Target nach Anspruch 24, dadurch gekennzeichnet, daß es aus einem Targetelement (2) mit einer Oberfläche in der Größenordnung von 400 cm$^2$ bis 1 m$^2$, das auf ein Metallsubstrat (4) mit einer entsprechenden Oberfläche aufgeklebt ist, besteht.

26. Target nach Anspruch 24, dadurch gekennzeichnet, daß es in Form eines Targets mit einer Oberfläche in der Größenordnung von 400 cm$^2$ bis 1 m$^2$ vorliegt, bestehend aus einer Vielzahl von Targetelementen (36, 37, 38) mit einer Oberlläche, die geringer als diejenige des Targets ist, die auf ein Metallsubstrat (24) mit einer Oberfläche aufgeklebt sind, die derjenigen des Targets entspricht, wobei sie auf dem Substrat aneinanderstoßend angeordnet sind und auf diesem eine der gewünschten Oberfläche für das Target entsprechende Oberfläche bedek-

ken.

27. Target nach einem der Ansprüche 24 bis 26, dadurch gekennzeichnet, daß das Metallsubstrat (4,24) eine Fläche, deren Kontur die Kontur des einzigen Targetelements (2) oder des sich aus der aneinanderstoßenden Anordnung der Targetelemente (36, 37, 38) mit kleiner Oberfläche ergebenden Targetelements (22) umgibt, wobei die Konturen vorzugsweise zueinander parallel verlaufen, und eine Randzone (14, 34) aufweist, die das Targetelement (2,22) umgibt, das auf diese Weise auf der Fläche des Metallsubstrats, auf das das oder die Targetelement(e) aufgeklebt ist(sind), abgegrenzt ist.

28. Target nach Anspruch 27, dadurch gekennzeichnet, daß in der Randzone (14, 34) Öffnungen (15, 35) münden, die das Metallsubstrat durchqueren und zur Aufnahme von Befestigungselementen bestimmt sind, die die Fixierung des Targets auf einem zu einer Vorrichtung für die Kathodenzerstäubung gehörenden Tragelement ermöglichen.

**Claims**

1. Target element (2, 22) for cathode sputtering constituted by a layer (16) of an inorganic chemical compound with a melting point above 300°C deposited on a supporting layer consisting of a metallic sponge or felt, the layer of the inorganic compound penetrating the supporting layer for at least a portion of its thickness and forming, with the latter, a composite layer (17) in which the inorganic compound and the support interpenetrate and the thickness of which is less than or equal to that of the supporting layer.

2. Target element according to Claim 1, characterized in that the thickness (e) of the composite layer represents from 10% to 100% and preferably from 50% to 100% of the total thickness ($e_s$) of the supporting layer.

3. Target element according to Claim 1 or Claim 2, characterized in that the thickness (e) of the composite layer represents from 10% to 100% and preferably from 20% to 80% of the total thickness ($e_c$) of the layer where the inorganic compound is present.

4. Target element according to any one of Claims 1 to 3, characterized in that the metallic sponge or felt used as the support for the inorganic compound is made of a metal or a metal alloy which is substantially inert with respect to the inorganic compound.

5. Target element according to any one of Claims 1 to 3, characterized in that the support for the inorganic compound is a sponge or a felt of gold, platinum, nickel, titanium or copper.

6. Target element according to any one of Claims 1 to 5, characterized in that the metallic sponge or felt has a porosity greater than 90%.

7. Target element according to any one of Claims 1 to 6, characterized in that the inorganic compound is a metal oxide, sulphide, halide or oxyhalide the melting point of which is above 300°C, the said inorganic compound being derived from one or a plurality of metals which may or may not be transition metals.

8. Target element according to any one of Claims 1 to 6, characterized in that the inorganic compound corresponds to one or other of the formulae $E_\alpha^k Z_\beta^P$ and $M_x^q T_y^n Z_z^p$, in which E represents a metal of groups I to VIII of the Periodic Table of Elements, for example, Fe, Cu, Co, Ni, Ti, Cr, Mo, W, Sn and In, each of M and T indicates a different metal of groups I to VIII of the said Periodic Table, for example Li, Na, K, Ag, Cu and Tl for M and Ni, Co, W, Mn, Fe, Cr, V and Ti for T, Z is an element selected from oxygen, sulphur, fluorine and chlorine, the symbols k, q, n and p indicate the mean oxidation states of the elements E, M, T and Z, respectively, $\alpha$ and $\beta$ indicate positive whole numbers such that $\alpha k+\beta p=0$ and x, y and z indicate positive whole numbers such that $qx+ny+pz=0$.

9. Target element according to any one of Claims 1 to 6, characterized in that the inorganic compound is an oxide and particularly an oxide corresponding to one or other of the formulae $E_\alpha^k O_\beta^{2-}$ and $M_x^q T_y^n O_z^{2-}$, in which E is a metal of groups I to VIII of the Periodic Table of Elements, for example, Fe, Cu, Co, Ni, W, Mo, Ti, Cr, Sn and In, each of M and T indicates a different metal of the said Periodic Table, for example Li, Na, K, Ag, Cu and Tl for M and Ni, Co, W, Mn, Cr, Fe, V and Ti for T, the symbols k, q and n indicating the mean oxidation states of E, M and T, respectively, $\alpha$ and $\beta$ are positive whole numbers such that $\alpha k-2\beta=0$ and x, y and z indicate positive whole numbers such that $qx+ny-2z=0$.

10. Method of preparing a target element according to Claim 1, such that a precursor system of an inorganic compound with a melting point above 300°C is applied to a support formed by a layer of metallic sponge or felt, the unit constituted by the support coated with the layer of the precursor system of the inorganic compound is subjected to a pressure of from 0.1 MPa to 15 MPa, the resulting unit is brought to a temperature of between 300°C and 1600°C suitable for bringing about sintering of the said unit, the said temperature being below the melting point of the support, and the unit being kept at the temperature reached for a period long enough to produce a sintered unit, the sintered unit then being cooled to bring it back to ambient temperature, this cooling being carried out in a manner such as to avoid any hardening phenomenon.

11. Method according to Claim 10, characterized in that the pressure to which the unit formed by the support coated with the layer of the precursor system of the inorganic compound is subjected is from 0.1 MPa to 5 MPa.

12. Method according to Claim 10 or Claim 11, characterized in that the temperature to which the unit is brought and at which it is kept after the action of the pressure is between 600°C and 1200°C.

13. Method according to any one of Claims 10 to 12, characterized in that the precursor system of the inorganic compound includes the inorganic compound itself, the said compound being, in particular, a compound of the formula $E_\alpha^k Z_\beta^P$, in which E represents a metal of groups I to VIII of the Periodic Table of Elements, for example, Fe, Cu, Co, Ni, Ti, Cr, Mo, W, Sn and In, Z is an element selected from oxygen, sulphur, fluorine and chlorine, the symbols k and p indicate the mean oxidation states of the elements E and Z, respectively, and $\alpha$ and $\beta$ are positive whole numbers such that $\alpha k+\beta p=0$.

14. Method according to any one of Claims 10 to 12, characterized in that the precursor system of the inorganic compound includes the inorganic compound itself, the said compound being an oxide and particularly an oxide of the formula $E_\alpha^k O_\beta^{2-}$, in which E is a metal of groups I to VIII of the Periodic Table of Elements, for example, Fe, Cu, Co, Ni, W, Mo, Ti, Cr, Sn and In, the symbol k indicates the mean oxidation state of the metal E, and $\alpha$ and $\beta$ are positive whole numbers such that $\alpha k-2\beta=0$.

15. Method according to any one of Claims 10 to 12, characterized in that the precursor system of the inorganic compound is formed by a mixture of ingredients leading, by chemical reaction at the temperatures selected for the sintering, to the desired inorganic compound.

16. Method according to Claim 15, characterized in that the inorganic compound is a compound of the formula $M_x^q T_y^n Z_z^p$, in which each of M and T indicates a different metal of groups I to VIII of the Periodic Table of Elements, for example Li, Na, K, Ag, Cu and Tl for M and Ni, Co, W, Mn Fe, Cr, V and Ti for T, Z is an element selected from oxygen, sulphur, fluorine and chlorine, the symbols q, n and p indicate the mean oxidation states of the elements M, T and Z, respectively, and x, y and z indicate positive whole numbers such that qx+ny+pz=0, and in that the precursor system of the inorganic compound consists of a mixture, in suitable proportions, of a compound of the metal M and of a compound of the metal T, which react at temperatures of between 300° and 1600°C to form the compound $M_x^q T_y^n Z_z^p$.

17. Method according to Claim 16, characterized in that the inorganic compound is an oxide and particularly an oxide of the formula $M_x^q T_y^n O_z^{2-}$ in which M, T, q and n have the meanings given in Claim 16 and x, y and z are positive whole numbers such that qx+ny-2z=0, and in that the precursor system of the said inorganic compound consists of a mixture of a carbonate of the metal M of formula $M_x^q (CO_3)qx/2$ and of an oxide $T_y^n O_{ny/2}^{2-}$ of the metal T.

18. Method according to any one of Claims 10 to 17, characterized in that the precursor system of the inorganic compound is in the form of a powder with a particle size suitable for the porosity of the support, and in that the precursor system is applied to the support by dusting of the support with the said powder.

19. Method according to any one of Claims 10 to 17, characterized in that the precursor system of the inorganic compound is in the form of a coating paste produced by the mixing of the precursor system in powder form with one or a plurality of liquids such as water or an organic liquid, or in the form of a gel produced from the precursor system in powder form by a sol/gel technique, and in that the precursor system is applied to the support by coating with the said paste or the said gel.

20. Method according to Claim 19, characterized in that the unit resulting from the coating of the support with the paste or the gel is subjected to a drying step to produce a substantially dry product, before being subjected to the action of the pressure.

21. Method according to any one of Claims 10 to 20, characterized in that the action of the pressure on the unit formed by the support coated with the precursor system of the inorganic compound is brought about in a manner such that the thickness of the supporting layer after the said action still represents at least 10% and preferably at least 50% of the initial thickness of the said supporting layer.

22. Method according to any one of Claims 10 to 21, characterized in that the unit subjected to the action of the pressure is subsequently brought to the temperature of between 300° and 1600°C at a rate of from 0.05°C to 30°C per minute and preferably from 0.1°C to 15°C per minute.

23. Method according to any one of Claims 10 to 22, characterized in that the cooling of the sintered unit from the temperature of between 300°C and 1600°C to ambient temperature is brought about at a rate of from 0.05°C to 30°C per minute and preferably from 0.1°C to 15°C per minute.

24. Cathode sputtering target consisting of a target element (2, 22) according to any one of Claims 1 to 9 glued, on the support side, to a metal substrate (4, 24), for example, a substrate of brass, aluminium, copper, titanium, tungsten or stainless steel, by means of an adhesive (3, 23) which conducts heat and electricity, particularly an adhesive consisting of a conductive two-component epoxy glue including silver.

25. Target according to Claim 24, characterized in that it consists of a target element (2) with a surface area of the order of from $400cm^2$ to $1m^2$, glued to a metal substrate (4) with a corresponding surface area.

26. Target according to Claim 24, characterized in that it is in the form of a target with a surface area of the order of from $400cm^2$ to $1m^2$, consisting of a plurality of target elements (36, 37, 38) with surface areas smaller than that of the said target, which are glued to a metal substrate (24) with a surface area corresponding to that of the target, being arranged edge to edge on the said substrate and covering, on this substrate, a surface area corresponding to the desired surface area for the target.

27. Target according to any one of Claims 24 to 26, characterized in that the metal substrate (4, 24) has a surface, the outline of which borders the outline of the single target element (2) or of the target element (22) resulting from the juxtaposition edge to edge of target elements (36, 37, 38) with small surface areas, the said outlines preferably being parallel to one another, a marginal region (14, 34) bordering the target element (2, 22) thus being defined on the surface of the metal substrate on which the target element or elements are glued.

28. Target according to Claim 27, characterized in that holes (15, 35) open in the said marginal region (14, 34) and extend through the metal substrate for the passage of fixing members enabling the target to be fixed to a support member belonging to a cathode sputtering device.

FIG.1a

FIG.1b

FIG.2a

FIG.2b